# EUROPEAN PATENT SPECIFICATION

(11) **EP 3 569 441 B1**
(45) Date of publication and mention of the grant of the patent: **04.12.2024**
(21) Application number: 19173455.7
(22) Date of filing: 09.05.2019
(51) Int. Cl.: B60L 53/18, H02J 7/00

(54) **METHOD FOR CONTROLLING A CHARGING PROCESS OF AN ELECTRIC VEHICLE AND CHARGING CABLE**
VERFAHREN ZUR STEUERUNG EINES LADEVORGANGS EINES ELEKTROFAHRZEUGS UND LADEKABEL
PROCÉDÉ DE COMMANDE D'UN PROCESSUS DE CHARGEMENT D'UN VÉHICULE ÉLECTRIQUE ET CÂBLE DE CHARGEMENT

(30) Priority: 15.05.2018 DE 102018111536
(43) Date of publication of application: 20.11.2019
(73) Proprietor: TE Connectivity Germany GmbH, 64625 Bensheim (DE)
(72) Inventor: KIPP, Stefan, 69168 Wiesloch (DE); KARRASCH, Gregor, 64683 Einhausen (DE)
(74) Representative: Patentanwaltskanzlei WILHELM & BECK

(56) References cited:
- DE-A1- 102015 206 047
- US-B2- 7 886 857

## Description

The invention relates to a method for controlling a charging process of an electric vehicle and to a charging cable, which is set up to control such a method.

Electric vehicles can be charged by being connected to a power network via a charging cable. In this case, there can be various technical implementations of the power network, for example a so-called TN network or a TT network, in which the power network is earthed to a power source and in which, on the one hand, a voltage can be tapped off between a neutral conductor and a voltage conductor, and in which, on the other hand, a protective conductor is provided, via which fault currents can be discharged and thus safer operation of electronic devices is possible. Alternatively, the power network can also be constructed as a so-called IT network, in which a voltage can be tapped off between two conductive phases and, at the same time, a protective earthing is provided only at the installation itself. The power source is therefore not earthed in an IT network.

In order to select a correct charging mode, for example depending on the power network to which the electric vehicle is connected by means of a charging cable, a communication can take place, between the charging cable and the power network, in which information about the power network is forwarded to the charging cable. The publication DE 10 2015 206 047 A1 discloses a plug system for such a charging cable, in which a communication between the power network and the charging cable, for example about the type of power network used, is possible by means of CAN bus technology.

This method is very complex, however, as additional electronic equipment must be provided for the communication. If no such communication means are provided on the network side, the charging cable cannot communicate with the network and thus also cannot ascertain the type of power network.

The patent US 7,886,857 B2 discloses a charging cable with a detection of a TN network as described above.

A problem of the invention is to provide a method for controlling a charging process of an electric vehicle, in which, using the known information, how TN networks, TT networks and IT networks are constructed, it can be ascertained which type of network is being dealt with, and on the basis of this discovery, to enable or not enable a charging process. A further problem of the invention is to provide a charging cable, which can be connected to an electric vehicle and to a power network, and, following the making of these connections, can ascertain which type of power network is being dealt with, and on the basis of this discovery, can enable a charging process.

These problems are solved by the method for controlling a charging process of an electric vehicle and by the charging cable of the independent patent claims. Further advantageous configurations are specified in the dependent patent claims.

A method for controlling a charging process of an electric vehicle envisages, as a first step, ascertaining a resistance between a network contact and a protective conductor of a network connection. In a TN network or TT network, the protective conductor and a neutral conductor lie on an identical potential. For this reason, ideally the resistance between the protective conductor and the neutral conductor is 0 ohm. If the resistance between one of the two network contacts and the protective earth conductor contact of a network connection of a charging cable is now measured, and one of these two resistances is 0 ohm, it can thus be expected that the corresponding power network is a functioning TN network or a functioning TT network. In a second method step, the determined resistance is compared to a predetermined value. This predetermined value can be, for example, the resistance value of 1.6 kiloohms laid down by the motor industry, in the case of which a functioning protective earthing can still be expected. This value corresponds to the maximum resistance value, at which safe triggering of an existing fault protection power switch-off is ensured in the case of a rated voltage of 230 volts of an alternating-current voltage. Alternatively, another predetermined value, for example a lower value, can also be selected. If the vehicle is connected to a TN network or to a TT network and the resistance value exceeds the predetermined value, then it can be expected that the protective earthing of the power network is no longer functioning correctly and, for this reason, a charging operation of an electric vehicle either should not be enabled or should be interrupted.

In an IT network, the protective earth conductor contact and network contacts are separated from one another, however, in such a way that in each case a resistance greater than the predetermined value is measured. Nevertheless, safe charging of the electric vehicle would be possible if it is connected to such an IT network by the charging cable. In the further method steps, it is now to be detected whether the network to which the vehicle is connected is an IT network, despite the high resistance between the protective earth conductor contact and the network contact. For this purpose, in a third method step, a time-variable voltage is applied to a vehicle connection of the charging cable. This time-variable voltage applied to the vehicle connection can be emitted into the substrate, namely into earth, by way of a capacitive or resistive coupling of the vehicle. This signal is transmitted to the network contact of the network connection via the protective earthing in a TN or TT network. In a fourth method step, it can be examined whether such a time-variable signal, triggered by the time-variable voltage being applied to the vehicle connection, can be detected at the first network contact of the network connection or at the second network contact of the network connection. If this is the case, then the power network used is a TN or TT network and the measured high resistance between the protective earth conductor contact and the network contact indicates a defective protective earthing, such that the charging process should not be enabled. If, however, the time-variable signal is not detectable at the first network contact of the network connection or at the second network contact of the network connection, then this is because the network contact in the IT system is not connected to earth, and for this reason the signal coupled into earth via the vehicle cannot be applied to the network contact. In this case, the connection of the electric vehicle to an IT network via the charging cable is therefore detected, and consequently for this reason, the charging process can be enabled. In a fifth method step, the charging process is therefore either enabled when the determined resistance is below the predetermined value or when the determined resistance is above the predetermined value and, at the same time, no time-variable signal can be detected at the protective earth conductor contact of the network connection. The method can therefore also serve to reliably identify a sufficient earthing regardless of the type of supply network. All method steps are performed by a control unit of the charging cable.

As a result, a universal charging cable can be used to connect the electric vehicle to differently configured power networks. A communication about this, transmitted between the charging cable and the power network, for ascertaining which type of network connection is being dealt with, is therefore not necessary.

As the time-variable voltage is applied to the protective earth conductor contact of the vehicle connection, the metal parts of the vehicle are available for capacitive or resistive transmission, the resistive transfer taking place via a high resistance of tyres of the vehicle.

It can be provided, in the first method step, to determine the resistance between the protective earth conductor contact and several network contacts and, in the fourth method step, to detect the signal at several network contacts. This is advantageous, in particular, when the charging cable cannot be plugged in a manner protected against polarity reversal, as neither the resistance nor the signal can be measured at the outer conductors of the power network.

In one embodiment of the method, the time-variable voltage is produced by means of a signal generator. This signal generator can be arranged inside the charging cable, and can be used to carry out the method.

In one embodiment of the method, the time-variable voltage is a pulsating direct-current voltage from a network rectifier. In this case, the network rectifier can therefore serve as a signal generator. It can be particularly advantageous, in this case, if the power network is an alternating-current voltage network, and the charging electronics situated in the charging cable require a direct-current voltage for the supply, to use an output voltage of a network rectifier to supply the control circuit as a time-variable voltage, since for this purpose the number of components required in the power cable is minimised.

In one embodiment of the method, the enabling of the charging process takes place by way of a switching of a relay. In this case, in particular one or more connections between the network connection and the vehicle connection can be switched from non-conductive to conductive. As a result, the flow of current from the network connection to the vehicle connection can be made possible.

In one embodiment, the time-variable voltage has a frequency. Upon detection at the network connection, filtering is performed in accordance with the frequency.

A charging cable for an electric vehicle has a network connection and a vehicle connection. The network connection has a first protective earth conductor contact, a first network contact and a second network contact. The vehicle connection has a second protective earth conductor contact and a first supply contact and also a second supply contact. The network contacts and the supply contacts, in this case, can serve to supply the vehicle with current, by the first network contact being wired with the first supply contact and the second network contact being wired with the second supply contact. The charging cable further has an electronic control system, which is set up to determine a resistance between one or both of the network contacts and the first protective earth conductor contact of the charging cable and to compare the determined resistance to a predetermined value. The electronic control system is further set up to apply a time-variable voltage to the vehicle connection of the charging cable and to detect a time-variable signal at the first network contact. Furthermore, the electronic control system is set up to enable a charging process when the determined resistance is below the predetermined value or when the determined resistance is above the predetermined value and, at the same time, no time-variable signal can be detected at the protective earth conductor contact of the network connection.

In one embodiment, the charging cable has a signal generator, which is set up to produce the time-variable voltage.

In one embodiment, the charging cable has a network rectifier. The network rectifier is arranged between the first network contact and the second network contact and outputs a supply voltage for the electronic control system. The time-variable voltage is a pulsating direct-current voltage. This pulsating direct-current voltage can be produced from the network rectifier, for example when the network rectifier is configured as a bridge circuit of four diodes.

In one embodiment, the charging cable has a relay between the network contacts and the supply contacts. The enabling of the charging process takes place via a switching of the relay.

In this case, the relay can switch the connection between the first network contact and the first supply contact and/or the connection between the second network contact and the second supply contact to conductive. As a result, the network voltage is applied to the electric vehicle and can be used to charge a storage cell of the electric vehicle.

In order to charge the electric vehicle, the charging cable is therefore first of all connected to the electric vehicle and to the network connection. The method according to the invention is then carried out by way of the electronic control system integrated in the charging cable, and in the process it uses the described methods to detect which type of power network is being dealt with or whether a protective earthing of the power network is intact. When the charging cable detects that, owing to the fact that the determined resistance is lower than the predetermined value and for this reason the protective earthing is intact, or that, owing to the fact that the time-variable signal cannot be ascertained at the network contact, it becomes clear that the charging cable is connected to an IT network, the charging process is enabled.

The problem of the invention, the technical implementation of the solution and the advantages of the invention become clear with reference to the exemplary embodiments, which are to be described hereinafter with the help of figures. In the figures, in a schematic depiction
- Fig. 1: shows a charging cable;
- Fig. 2: shows a plug pin arrangement of a charging cable;
- Fig. 3: shows a further plug pin arrangement of a charging cable; and
- Fig. 4: shows a circuit diagram of wiring inside a charging cable and a vehicle.

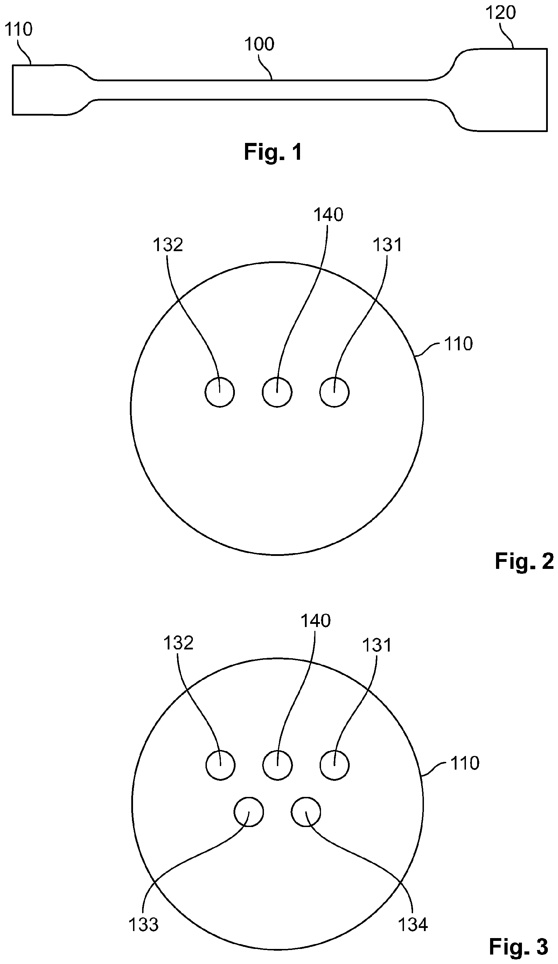

Fig. 1 shows a charging cable 100, by means of which an electric vehicle can be connected to a network connection. For this purpose, the charging cable has a network connection 110 and a vehicle connection 120. The network connection 110 and the vehicle connection 120 can, in this case, be designed as a plug and/or a socket.

Fig. 2 shows a plug pin arrangement of the network connection 110 of Fig. 1. A first network contact 131 and a second network contact 132 can be used to supply electricity to the charging cable 100 and the vehicle. Furthermore, a first protective earth conductor contact 140 is available, with which a connection of a protective earth to the vehicle can be made. In a TN or TT network, a neutral conductor of the network can be connected to the first network contact 131, and one of three outer conductors of the network can be connected to the second network contact 132. In an IT network, a first outer conductor can be connected to the first network contact 131, and a second outer conductor of the power network can be connected to the second network contact 132.

Fig. 3 shows a network connection 110, which corresponds to the standard for mode-2 charging cables. The network connection 110 has a first network contact 131, which is connected to a neutral conductor of the power network. Furthermore, a second network contact 132, a third network contact 133 and a fourth network contact 134 are arranged, which are each connected to one of three outer conductors of the power network. A first protective earth conductor contact 140 serves to connect a protective earthing. Through such a plug pin arrangement of the network connection 110, relatively high charging currents are possible, since a three-phase current between two outer conductors of the network can also be used to charge a vehicle.

The vehicle connection 120 can be constructed analogously to the network connections shown in Figures 2 and 3. Furthermore, there can be further contacts, for example defined for the mode-2 charging cable in European Standard 62196 type 2, for example for ascertaining whether a plug is plugged in or in order to exchange control signals between the electric vehicle and the network connection. Furthermore, additional direct-current voltage contacts can also be provided.

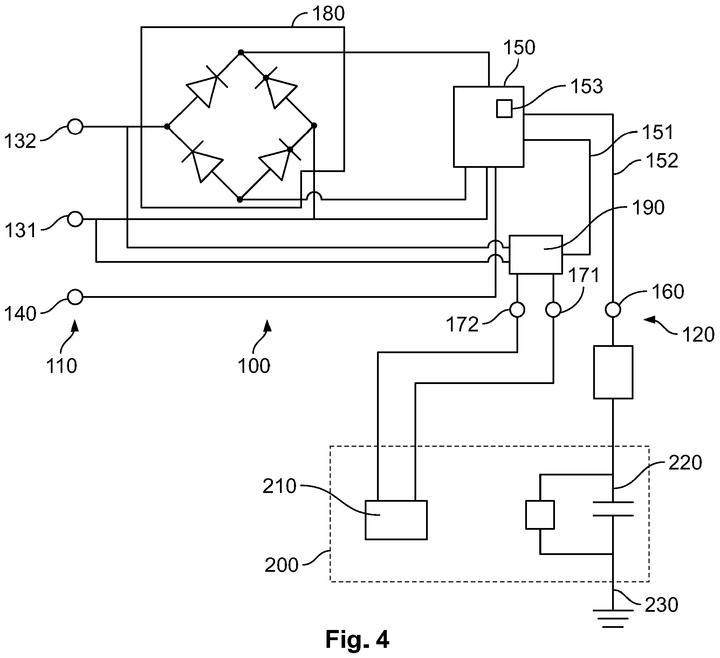

Fig. 4 shows inner wiring of a charging cable 100 between the vehicle connection 120 and the network connection 110. The network connection 110 has a first network contact 131, a second network contact 132 and a first protective earth conductor contact 140. The vehicle connection 120 has a first supply contact 171 and a second supply contact 172 and also a second protective earth conductor contact 160. The first supply contact 171 and the second supply contact 172 are connected to a vehicle battery 210 of an electric vehicle 200, the vehicle battery 210 and the electric vehicle 200 not being part of the charging cable 100. The electric vehicle 200 is coupled capacitively and resistively to earth 230 via a vehicle impedance 220 via the second protective earth conductor contact 160. The second protective earth conductor contact 160 can, in this case, be connected to metal parts of the electric vehicle 200. The capacitive coupling then arises from the capacitance between these metal parts and the substrate, while the resistive coupling can take place via the tyres.

The charging cable 100 has a control unit 150. Between the first network contact 131 and the second network contact 132 there is arranged a network rectifier 180, here consisting of a bridge circuit of four diodes. By means of the network rectifier 180, a direct-current voltage can be provided for the control unit 150. In this case, the network rectifier 180 can receive further components, for example a transformer and/or a capacitor for smoothing the direct-current voltage produced, these components not being depicted in Fig. 4, but being known to the person skilled in the art in relation to the production of a direct-current voltage for an electronic control system from an alternating-current voltage. The control unit 150 is set up to ascertain a resistance between the first protective earth conductor contact 140 and the first network contact 131. Furthermore, the control unit 150 is set up to compare the ascertained resistance between the first protective earth conductor contact 140 and the first network contact 131 to a predefined value. The electronic control system is connected to a switch 190 via a control conducting component 151. The switch 190 is connected to the first network contact 131 and to the second network contact 132 and also to the first supply contact 171 and to the second supply contact 172.

If it arises from the comparison of the resistance between the first protective earth conductor contact 140 and the first network contact 131 to the predetermined value that the ascertained resistance value lies below the predetermined value, the charging of the electric vehicle 200 can be enabled by means of the switch 190, by the first network contact being connected to the first supply contact and the second network contact being connected to the second supply contact. This can take place by switching on the conductivity of one or both of the two connections, in the first case the second connection being performed in a continuously guided and non-switchable manner.

If the charging cable 100 is connected to a TN or TT network, in the case of the TN network the first protective earth conductor contact 140 is electrically conductively connected to the first network contact 131, which in this case is designed as a neutral conductor. In the TT network, the connection between the first protective earth conductor contact 140 and the first network contact 131 takes place via earth and the earthing of the power source. In both cases, only a low resistance is measured between the first protective earth conductor contact 140 and the first network contact 131, the resistance ideally being 0 ohm in the case of perfect earthing and it also being possible for low resistances to still lead to a sufficient protective earthing. The predetermined value can be 1.6 kiloohms, for example, as a sufficient earthing can still be expected between the first protective earth conductor contact and the first network contact in the case of a resistance of 1.6 kiloohms.

Through the detection of such a low resistance, it can therefore be ascertained that the electric vehicle 200 is connected to a TN or TT network with an intact protective earthing. In this case, the charging process can be enabled via the switch 190.

If the resistance between the first protective earth conductor contact 140 and the first network contact 131 were to lie above the predetermined value of 1.6 kiloohms, for example, this is an indication, when the charging cable 100 is connected to a TN or TT network, that the protective earth is not sufficiently shielding, and correspondingly a charging process should not be enabled in a TN or TT network.

If, however, the charging cable 100, and with it the electric vehicle 200, is connected to an IT network, the first network contact 131 and the second network contact 132 are each laid on an outer conductor of the IT network. The first protective earth conductor contact 140 is not connected to the first network contact 131, as the latter is guided from a non-earthed power source directly to the first network contact 131 without interposed earthing. As a result, the resistance between the first network contact 131 and the first protective earth conductor contact 140 is infinitely large, such that the switch 190 initially should not be switched and thus the charging of the electric vehicle 200 should be enabled. The control unit 150 is connected to the second protective earth conductor contact 160 via a signal contact 152. If too high a resistance is registered between the first protective earth conductor contact 140 and the first network contact 131, consequently the control unit 150 is set up to apply a time-variable voltage to the second protective earth conductor contact 160 via the signal contact 152. This time-variable voltage is coupled into earth 230 via the vehicle impedance 220. As a result of the fact that the first network contact 131 is connected to earth via the protective earth in a TN network and is connected to earth via the earthing of the power source in a TT network, this signal coupled into earth can be tapped off again at the first network contact 131. The control unit 150 is set up to ascertain this signal at the first network contact and, should such a signal be ascertained, to set the switch 190 to non-conductive via the control conducting component 151. If, however, the charging cable 100 and thus the electric vehicle 200 is connected to an IT network, the first network contact 131 is thus separated galvanically from earth 230, and the signal outputted to earth 230 via the vehicle impedance 220 cannot be tapped off at the first network contact 131. In this case, the control unit 150 is set up likewise to set the switch 190 to conductive, since as a result of the absence of the time-variable signal the connection of the charging cable 100 and the electric vehicle 200 to an IT network was detected, and in the latter the enabling of the charging process is safe. The control unit 150 can be configured as an electronic control system.

Likewise, Fig. 4 depicts an optional signal generator 153, by which the time-variable voltage can be produced, which is then applied to the signal contact 152 and thus to the second protective earth conductor contact 160.

In one embodiment, the control unit 150 and/or the signal generator 153 is set up to produce the time-variable voltage from the pulsating direct-current voltage produced by the network rectifier 180.

In one exemplary embodiment, the switch 190 is a relay. As an alternative to a relay, the switch 190 can also be designed as a high-performance MOSFET, as a high-performance diode or as a semiconductor switch of different design.

It can be envisaged that the time-variable voltage has a frequency and the control unit 150 is set up to filter the signal tapped off at the first network contact 131 in accordance with this frequency. As a result, the signal yield can be increased considerably.

It can be provided to measure the resistance between the first protective earth conductor contact 140 and both network contacts 131, 132 and to detect the signal at both network contacts 131, 132, in particular when the charging cable 100 does not have plugs which are protected against polarity reversal. In order to enable the charging process, one of the measured resistances must then lie below the predetermined value or the variable signal can be detected at one of the network contacts 131, 132.

Although the invention has been described and depicted more closely in detail by way of the preferred exemplary embodiments, the invention is not limited by the disclosed exemplary embodiments. Other variations can be derived therefrom and from the description of the invention, without departing from the scope of protection of the appended claims.

## Claims

1. A method for controlling a charging process of an electric vehicle (200) with the following steps, executed by a control unit (150) of a charging cable (100):
- determining a resistance between a first and/or a second network contact (131, 132) and a first protective earth conductor contact (140) of a network connection (110) of the charging cable (100);
- comparing the determined resistance to a predetermined value;
- applying a time-variable voltage to a second protective earth conductor contact (160) of a vehicle connection (120) of the charging cable (100);
**characterized by** the following steps:
- examining whether a time-variable signal, triggered by the time-variable voltage being applied to the vehicle connection (120), can be detected at the first network contact (131) and/or at the second network contact (132) of the network connection (110) ;
- enabling a charging process when either the determined resistance is below the predetermined value or the determined resistance is above the predetermined value and, at the same time, no time-variable signal can be detected at the network connection (110).

2. The method according to Claim 1, wherein the time-variable voltage is produced by means of a signal generator (153).

3. The method according to any one of Claims 1 or 2, wherein the time-variable voltage is a pulsating direct-current voltage from a network rectifier (180).

4. The method according to any one of Claims 1 to 3, wherein the enabling of the charging process takes place by way of a switching of a relay.

5. The method according to any one of Claims 1 to 4, wherein the time-variable voltage has a frequency and wherein, upon detection at the network connection (110), filtering is performed in accordance with the frequency.

6. A charging cable (100) for an electric vehicle (200) with a network connection (110) and a vehicle connection (120), wherein the network connection (110) has a first protective earth conductor contact (140), a first network contact (131) and a second network contact (132), wherein the vehicle connection (120) has a second protective earth conductor contact (160) and a first supply contact (171) and a second supply contact (172), wherein the charging cable (100) has a control unit (150), wherein the control unit (150) is set up to determine a resistance between one of the network contacts (131, 132) and the first protective earth conductor contact (140) of the charging cable (100), to compare the determined resistance to a predetermined value, **characterized in that** the control unit (150) is set up to apply a time-variable voltage to the second protective earth conductor contact (160) of the vehicle connection (120) of the charging cable (100), to detect a time-variable signal at the first network contact (131) of the first network contact (131) and/or at the second network contact (132), and wherein the control unit (150) is set up to enable a charging process when either the determined resistance is below the predetermined value or the determined resistance is above the predetermined value and, at the same time, no time-variable signal can be detected at the network connection (110).

7. The charging cable (100) according to Claim 6, further having a signal generator (153), wherein the signal generator (153) is set up to produce the time-variable voltage.

8. The charging cable (100) according to Claim 6 or 7, further having a network rectifier (180), wherein the network rectifier (180) is arranged between the first network contact (131) and the second network contact (132), wherein the network rectifier (180) outputs a supply voltage for the control unit (150), wherein the time-variable voltage is a pulsating direct-current voltage.

9. The charging cable (100) according to any one of Claims 6 to 8, further having a relay (190) between the network contacts (131, 132) and the supply contacts (171, 172), wherein the enabling of the charging process takes place via a switching of the relay (190).

## Patentansprüche

1. Verfahren zum Steuern eines Ladeprozesses eines Elektrofahrzeugs (200) mit den folgenden Schritten, ausgeführt durch eine Steuereinheit (150) eines Ladekabels (100):
- Bestimmen eines Widerstandes zwischen einem ersten und/oder einem zweiten Netzwerkkontakt (131, 132) und einem ersten Erdungs-Schutzleiterkontakt (140) eines Netzwerkanschlusses (110) des Ladekabels (100) ;
- Vergleichen des bestimmten Widerstandes mit einem vorbestimmten Wert;
- Anlegen einer zeitlich veränderlichen Spannung an einen zweiten Erdungs-Schutzleiterkontakt (160) eines Fahrzeuganschlusses (120) des Ladekabels (100) ;
**gekennzeichnet durch** folgende Schritte:
- Prüfen, ob an dem ersten Netzwerkkontakt (131) und/oder an dem zweiten Netzwerkkontakt (132) des Netzwerkanschlusses (110) ein zeitlich veränderliches Signal, ausgelöst durch das Anlegen der zeitlich veränderlichen Spannung an den Fahrzeuganschluss (120), erkannt werden kann;
- Ermöglichen eines Ladeprozesses, wenn entweder der bestimmte Widerstand unter dem vorbestimmten Wert liegt oder der bestimmte Widerstand über dem vorbestimmten Wert liegt und gleichzeitig kein zeitlich veränderliches Signal an dem Netzwerkanschluss (110) erkannt werden kann.

2. Verfahren nach Anspruch 1, wobei die zeitlich veränderliche Spannung mit Mitteln eines Signalgenerators (153) erzeugt wird.

3. Verfahren nach einem der Ansprüche 1 oder 2, wobei die zeitlich veränderliche Spannung eine pulsierende Gleichspannung aus einem Netzwerk-Gleichrichter (180) ist.

4. Verfahren nach einem der Ansprüche 1 bis 3, wobei das Ermöglichen des Ladeprozesses durch das Schalten eines Relais erfolgt.

5. Verfahren nach einem der Ansprüche 1 bis 4, wobei die zeitlich veränderliche Spannung eine Frequenz hat und wobei bei Erkennung an dem Netzwerkanschluss (110) eine Filterung in Übereinstimmung mit der Frequenz durchgeführt wird.

6. Ladekabel (100) für ein Elektrofahrzeug (200) mit einem Netzwerkanschluss (110) und einem Fahrzeuganschluss (120), wobei der Netzwerkanschluss (110) einen ersten Erdungs-Schutzleiterkontakt (140), einen ersten Netzwerkkontakt (131) und einen zweiten Netzwerkkontakt (132) aufweist, wobei der Fahrzeuganschluss (120) einen zweiten Erdungs-Schutzleiterkontakt (160) und einen ersten Versorgungskontakt (171) und einen zweiten Versorgungskontakt (172) aufweist, wobei das Ladekabel (100) eine Steuereinheit (150) aufweist, wobei die Steuereinheit (150) eingerichtet ist, einen Widerstand zwischen einem der Netzwerkkontakte (131, 132) und dem ersten Erdungs-Schutzleiterkontakt (140) des Ladekabels (100) zu bestimmen, um den bestimmten Widerstand mit einem vorbestimmten Wert zu vergleichen, **dadurch gekennzeichnet, dass** die Steuereinheit (150) eingerichtet ist, eine zeitlich veränderliche Spannung an den zweiten Erdungs-Schutzleiterkontakt (160) des Fahrzeuganschlusses (120) des Ladekabels (100) anzulegen, um ein zeitlich veränderliches Signal am ersten Netzwerkkontakt (131) des ersten Netzwerkkontakts (131) und/oder am zweiten Netzwerkkontakt (132) zu erkennen, und wobei die Steuereinheit (150) eingerichtet ist, einen Ladeprozess zu ermöglichen, wenn entweder der bestimmte Widerstand unter dem vorbestimmten Wert liegt oder der bestimmte Widerstand über dem vorbestimmten Wert liegt und gleichzeitig kein zeitlich veränderliches Signal an dem Netzwerkanschluss (110) erkannt werden kann.

7. Ladekabel (100) nach Anspruch 6, ferner mit einem Signalgenerator (153), wobei der Signalgenerator (153) eingerichtet ist, die zeitlich veränderliche Spannung zu erzeugen.

8. Ladekabel (100) nach Anspruch 6 oder 7, ferner mit einem Netzwerk-Gleichrichter (180), wobei der Netzwerk-Gleichrichter (180) zwischen dem ersten Netzwerkkontakt (131) und dem zweiten Netzwerkkontakt (132) angeordnet ist, wobei der Netzwerk-Gleichrichter (180) eine Versorgungsspannung für die Steuereinheit (150) ausgibt, wobei die zeitlich veränderliche Spannung eine pulsierende Gleichspannung ist.

9. Ladekabel (100) nach einem der Ansprüche 6 bis 8, ferner mit einem Relais (190) zwischen den Netzwerkkontakten (131, 132) und den Versorgungskontakten (171, 172), wobei das Ermöglichen des Ladeprozesses über ein Schalten des Relais (190) erfolgt.

## Revendications

1. Procédé de commande d'un processus de charge d'un véhicule électrique (200) avec les étapes suivantes, exécuté par une unité de commande (150) d'un câble de charge (100) :
- détermination d'une résistance entre un premier et/ou un deuxième contact de réseau (131, 132) et un premier contact conducteur de terre protecteur (140) d'une connexion réseau (110) du câble de charge (100) ;
- comparaison de la résistance déterminée à une valeur prédéterminée ;
- application d'une tension variable dans le temps à un deuxième contact conducteur de terre protecteur (160) d'une connexion de véhicule (120) du câble de charge (100) ;
**caractérisé par** les étapes suivantes :
- examen si un signal variable dans le temps, déclenché par le fait que la tension variable dans le temps est appliquée à la connexion de véhicule (120), peut être détecté au niveau du premier contact de réseau (131) et/ou au niveau du deuxième contact de réseau (132) de la connexion réseau (110) ;
- activation d'un processus de charge lorsque soit la résistance déterminée est en dessous de la valeur prédéterminée soit la résistance déterminée est au-dessus de la valeur prédéterminée et, en même temps, aucun signal variable dans le temps ne peut être détecté au niveau de la connexion réseau (110).

2. Procédé selon la revendication 1, la tension variable dans le temps étant produite au moyen d'un générateur de signal (153).

3. Procédé selon l'une quelconque des revendications 1 et 2, la tension variable dans le temps étant une tension à courant continu à impulsions provenant d'un redresseur de réseau (180).

4. Procédé selon l'une quelconque des revendications 1 à 3, l'activation du processus de charge prenant place au moyen d'une commutation d'un relai.

5. Procédé selon l'une quelconque des revendications 1 à 4, la tension variable dans le temps ayant une fréquence et, lors de la détection au niveau de la connexion réseau (110), un filtrage étant réalisé en fonction de la fréquence.

6. Câble de charge (100) pour un véhicule électrique (200) avec une connexion réseau (110) et une connexion de véhicule (120), la connexion réseau (110) présentant un premier contact conducteur de terre protecteur (140), un premier contact de réseau (131) et un deuxième contact de réseau (132), la connexion de véhicule (120) présentant un deuxième contact conducteur de terre protecteur (160) et un premier contact d'alimentation (171) et un deuxième contact d'alimentation (172), le câble de charge (100) présentant une unité de commande (150), l'unité de commande (150) étant configurée pour déterminer une résistance entre un des contacts de réseau (131, 132) et le premier contact conducteur de terre protecteur (140) du câble de charge (100), pour comparer la résistance déterminée à une valeur prédéterminée, **caractérisé en ce que** l'unité de commande (150) est configurée pour appliquer une tension variable dans le temps au deuxième contact conducteur de terre protecteur (160) de la connexion de véhicule (120) du câble de charge (100), pour détecter un signal variable dans le temps au niveau du premier contact de réseau (131) du premier contact de réseau (131) et/ou au niveau du deuxième contact de réseau (132), et l'unité de commande (150) étant configurée pour activer un processus de charge lorsque soit la résistance déterminée est en dessous de la valeur prédéterminée soit la résistance déterminée est au-dessus de la valeur prédéterminée et, en même temps, aucun signal variable dans le temps ne peut être détecté au niveau de la connexion réseau (110).

7. Câble de charge (100) selon la revendication 6, présentant en outre un générateur de signal (153), le générateur de signal (153) étant configuré pour produire la tension variable dans le temps.

8. Câble de charge (100) selon la revendication 6 ou 7, présentant en outre un redresseur de réseau (180), le redresseur de réseau (180) étant agencé entre le premier contact de réseau (131) et le deuxième contact de réseau (132), le redresseur de réseau (180) délivrant une tension d'alimentation pour l'unité de commande (150), la tension variable dans le temps étant une tension à courant continu à impulsions.

9. Câble de charge (100) selon l'une quelconque des revendications 6 à 8, présentant en outre un relai (190) entre les contacts de réseau (131, 132) et les contacts d'alimentation (171, 172), l'activation du processus de charge prenant place via une commutation du relai (190).
